# EUROPÄISCHE PATENTANMELDUNG

(11) **EP 1 126 505 A2**
(43) Veröffentlichungstag der Anmeldung: **22.08.2001**
(21) Anmeldenummer: 00127200.4
(22) Anmeldetag: 13.12.2000
(51) Int. Cl.: H01L 21/00

(54) **Verfahren und Vorrichtung für die nasschemische Reinigung und Ätzung von scheibenförmigen Einzelsubstraten**

(30) Priorität: 17.02.2000 DE 10007248
(71) Anmelder: CONTRADE Mikrostruktur Technologie GmbH, 75446 Wiernsheim (DE)
(72) Erfinder: Kunze-Concewitz, Horst, 75446 Wiernsheim (DE)
(74) Vertreter: Steimle, Josef, Dipl.-Ing.

(57) **Zusammenfassung**

Die Erfindung betrifft ein Verfahren zum naßchemischen Reinigen und Ätzen von scheibenförmigen Substraten in einer geschlossenen Prozesskammer, dadurch gekennzeichnet, dass das zu bearbeitende Substrat von einer Substrataufnahme aufgenommen wird, dass das Substrat in Rotation versetzt und gleichzeitig beide Seiten des Substrats mit Chemikalien besprüht werden.

## Beschreibung

Die Erfindung betrifft eine ein Verfahren und Vorrichtung für die naßchemische Reinigen und Ätzung von scheibenförmigen Substraten (Wafern), die für die Herstellung mikroelektronischer Bauelemente eingesetzt werden.

Neben physikalischen Reinigungsverfahren (wie z. B. Bürstenreinigung, Megasonic Dampfreinigung) werden für die Reinigung von Wafern, d.h. Beseitigung von Kontaminationen (wie z. B. organischen Partikel-Metallionen-Kontaminationen) sowie natürlichen Oxyden auf der Waferoberfläche, werden Chemikalien wie H₂SO₄, H₂O₂, HF, NH₄OH, DI-H₂O (deionisierte Wasser) usw. in hoher Konzentration bzw. Chemikalien-Gemische für Verfahren wie RCA, SC1, SC2 eingesetzt.

Bei den teilweise sehr aggressiven Chemikalien werden für die chemische Bearbeitung vorzugsweise Tauchanlagen eingesetzt, indem die Scheiben in Prozeßbecken, die mit Chemikalien gefüllt sind, getaucht werden.

Der Vorteil der Tauchanlagen ist, daß der Wafer in einem Bad von beiden Seiten chemisch bearbeitet wird, und daß durch das Eintauchen von mehreren in einem Carrier untergebrachten Sustraten, die auf einmal getaucht werden, der Durchsatz relativ hoch ist.

Die Nachteile solcher Anlagen ist der hohe ChemikalienVerbrauch, sowie die hohe Chemikalien-Bevorratung, ein großer Platzbedarf im Reinraum und hohe Anschaffungskosten. Zudem ist nur die Bearbeitung von mehreren Substraten auf einmal, wegen der langen Prozesszeiten beim Tauchverfahren, möglich.

Mit höherer Integration der Bauelemente auf einem Wafer und mit größer werdenden Waferdurchmessern steigt die Forderung nach Einzelscheibenbearbeitung um reproduzierbar jeden Wafer exakt gleich zu prozessieren, was bei den Tauchanlagen nicht gewährleistet ist.

Der Einsatz von Sprühätzanlagen bekannter Bauweise, wie z.B. Durchlaufsprühanlagen schließt sich dadurch aus, daß mit sehr aggressiven Chemikalien gearbeitet wird, das Substrat von beiden Seiten gleichmäßig bearbeitet werden muß, und zudem mit sehr hohen Prozeßparametern Anforderungen in Bezug auf Gleichmäßigkeit des chemischen Angriffs, Partikelfreiheit, Metallionenkontaminationen etc. so daß der Aufbau der Prozeßkammer sehr spezielle Anforderungen erfüllen muß.

Die teilweise eingesetzten Spin-Prozessoren, bei denen ein einzelner Wafer auf einer Aufnahme (Chuck) rotiert und durch Chemikalien dabei besprüht wird, haben den Nachteil, daß die Gleichbehandlung der Vorder- u. Rückseite gleichzeitig wegen der Substrataufnahme nicht möglich ist. Das Substrat muß in der Aufnahme gewendet und nacheinander Vorder- und Rückseite bearbeitet werden. Werden mehrere Prozesse nacheinander durchgeführt, wird die Prozeßzeit bei den Spinprozessoren pro Wafer zu lang. Somit ist der Durchsatz gering. Eine Kombination in einer Anlage mit physikalischen Reinigungsverfahren ist allein aufgrund der notwendigen Materialbeständigkeit gegenüber den Chemikalien zudem nicht möglich.

Werden mehrere Spinprozessoren eingesetzt, sind sowohl die Anlagenkosten zu hoch, die Abmessungen zu groß und das Handling zwischen den Prozessoren wird zu aufwendig und teuer.

Der Erfindung liegt daher die Aufgabe zugrunde, ein Verfahren und eine Vorrichtung für die naßchemische Reinigung und Ätzung von scheibenförmigen Substraten (Wafern) bereitzustellen, bei dem mehrere Wafer gleichzeitig prozessiert werden können, bei dem einzelne Substrate gleichzeitig von beiden Seiten mit chemischen Verfahren bearbeitet werden können.

Die Aufgabe wird erfindungsgemäß mit einem Verfahren mit den Merkmalen des Anspruchs 1 und einer Vorrichtung mit den Merkmalen des Anspruchs gelöst.

Die Aufgabe wird also erfindungsgemäß mit einer Vorrichtung und einem Verfahren gelöst, in dem der zu bearbeitende Wafer vertikal in einer Aufnahme im Randbereich (3 Punkte) gehalten wird. Die Aufnahme kann durch einen Antrieb in Rotation versetzt werden. Diese rotierende Aufnahme befindet sich ihrerseits in einer Prozeßkammer die aus zwei Teilen besteht, welche zum Beladen des Wafers auseinandergefahren wird. Die Chemikalien für die chemische Bearbeitung werden von beiden Seiten auf das Substrat bei geschlossener Prozeßkammer gesprüht. Beim Sprühen rotiert das Substrat, dadurch wird sowohl die gleichmäßige Medienverteilung auf der Oberfläche erreicht als auch ein Abschleudern der auf der Oberfläche bereits wirksamen und somit verbrauchten Chemikalien. Nach chemischer Bearbeitung erfolgt eine Spülung des Substrats mit Wasser; ebenso kann das Substat für den Weitertransport trockengeschleudert werden. Nach erfolgter Spülung wird die Prozeßkammer geöffnet, das Substrat über einen Greifer von der Substrataufnahme entnommen und z.B. über eine Transporteinrichtung oder ein Handlingsroboter in die nächste gleich aufgebaute Prozeßkammer einer weiteren chemischen Bearbeitung zugeführt oder zum Trockenschleudern in eine Trockenschleuder beladen. Durch Aufbau mehrerer Prozeßkammern können die Substrate, die jeweils von Prozeßkammer zu Prozeßkammer transportiert werden, zeitgleich in der jeweiligen Kammer prozessiert werden, wodurch ein entsprechend hoher Durchsatz erreicht wird.

Ein großer Vorteil der Erfindung ist die hohe Ätzratenhomogenität durch gleichmäßigen Chemikalienangriff, die geringe Partikelgeneration, sowie die geringe Metallionenkontamination. Außerdem ist der Durchsatz hoch, die Kombination von physikalischen und chemischen Reinigungsverfahren innerhalb einer Anlage einfach zu realisieren und die benötigte Fläche der Anlage im Reinraum mit zunehmend steigenden Substratabmessungen (z.B. 300 mm, 400 mm, usw.) gering.

Der Aufbau der Prozeßkammer ist rotationssymetrisch, um Turbulenzen des rotierenden Substrats zu minimieren. Neben dem rotationssymetrischen Aufbau der Substrataufnahme und der Prozeßkammer wird die Form und Oberflächenbeschaffenheit aller in der Kammer befindlichen Teile so gewählt, daß eine einfache aber sehr gründliche Spülung und somit automatische Reinigung der Prozeßkammern erfolgt, wodurch auch die Partikelkontamination in der Prozeßkammer minimiert wird.

Der sehr einfache Aufbau der Prozeßkammer und der Substrataufnahme erlaubt die Fertigung aus beständigen Kunststoffen gegenüber den eingesetzten aggressiven Chemikalien, wodurch auch den hohen Anforderungen an geringe Metallionenkontaminationen Rechnung getragen wird.

Die geschlossene Prozeßkammer erlaubt den Einsatz aggressiver Chemikalien, ohne daß sehr aufwendige Vorkehrungen an der gesamten Anlage bezüglich der Materialbeständigkeit und Sicherheit geschaffen werden müssen. Der vertikale Prozeß der Wafer ermöglicht sehr geringe Anlagenabmessungen. Die aufgesprühten und abgeschleuderten Chemikalien werden über einen Ablauf in der Prozeßkammer gesammelt und wieder aufbereitet. Damit soll ein minimaler Chemikalienverbrauch und eine gleichbleibende Ätzratenhomogenität von Substrat zu Substrat sichergestellt werden, weil jedes Substrat unter gleichen Bedingungen (gleichbleibende Chemikalienkonzentration) prozessiert wird.

Zur Prozessoptimierung jedes einzelnen Wafers ist zudem der Einsatz von Endpunktdetektoren möglich, so daß der Prozeß für jeden Wafer optimal gesteuert werden kann, ohne daß z.B. die Medienparameter (Temperatur, Konzentration, Sprühmenge etc.) von Wafer zu Wafer exakt eingehalten werden müssen, sondern der Prozeß über den Detektor bestimmt wird.

Zur Vermeidung einer Crosskontamination innerhalb der gesamten Anlage, wird ein hin und her taktendes Wafertransportsystem eingesetzt, das die Wafer jeweils nur von einer zur nächsten Prozeßstation transportiert, und nach ausgeführtem Transport wieder in die Ausgangsposition zurück taktet. Dadurch wird die Verschleppung von Partikeln, die z.B. bei einem durchgehenden Transportband möglich wären vermieden.

Die Düsen für das Sprühen der Chemikalien werden durch nachfolgendes Sprühen von Spülmedien (in den meisten Fällen Wasser) zwischen den Prozeßschritten gereinigt. Das erfolgt indem die Sprühdüse an eine Ventilbatterie angeschlossen ist, so daß unterschiedliche Chemikalien nacheinander gesprüht werden können und die Sprühdüse auch mit Wasser gespült werden kann.

Die Zuführung der Chemikalien kann über eine kombinierte Ventilbatterie und Mischeinrichtung erfolgen, so daß auch ein Mischverhältnis der Zusammensetzung der Ätzlösung bei Bedarf unmittelbar vor dem Aufsprühen erfolgen kann. Das ist insbesondere wichtig, wenn man mit Chemikaliengemischen arbeitet, die nicht zeitstabil sind und somit eine längere Bevorratung als Gemisch nicht zulassen.

Ebenso ist das Aufsprühen unterschiedlicher Prozeßchemikalien aus verschiedenen Düsen möglich, so daß die Mischung der Chemikalien erst auf der Substratoberfläche erfolgt.

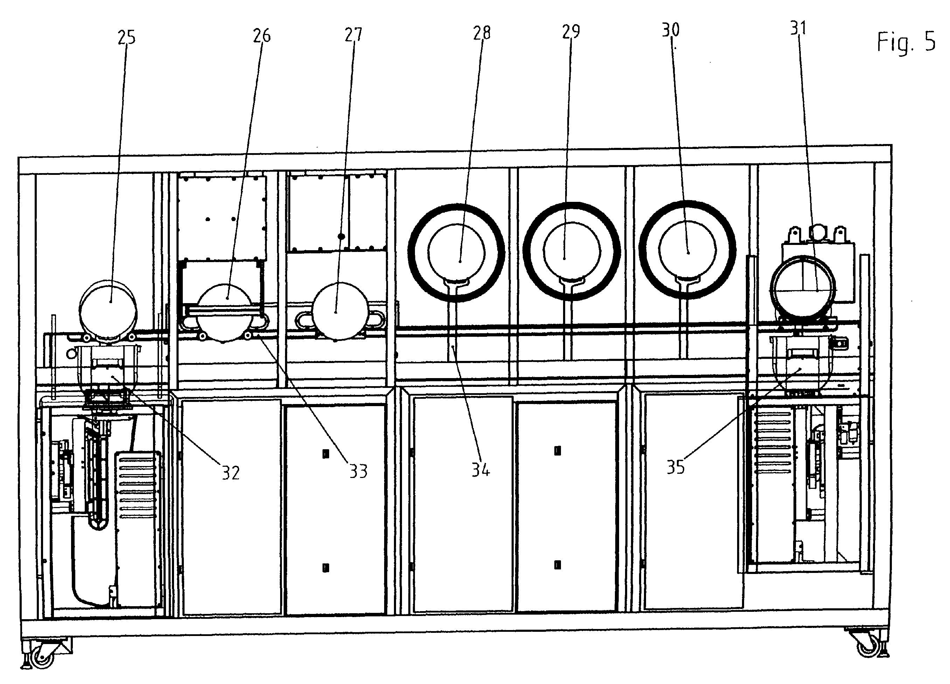

Erfindungsgemäß können unterschiedliche bzw. alle Reinigungs-, Ätz- u. Sprühprozesse in einer Prozeßkammer nacheinander durchgeführt werden, z.B. in Laboranlagen. Zwischen den einzelnen Prozessen ist jeweils ein Spülprozeß, gegebenenfalls eine Kammerreinigung möglich. Die Integration der chemischen Bearbeitung kann einfach in Anlagen mit physikalischer Reinigung integriert werden, so daß nacheinander die Verfahren in aufeinanderfolgenden Prozeßkammern erfolgen (Fig. 5). Sowohl das Substrathandling aus den Magazinen, als auch innerhalb der Anlage, erfolgt mit einem vertikal ausgerichteten bzw. positionierten Wafer.

Weitere Vorteile, Merkmale und Einzelheiten ergeben sich aus den Unteransprüchen sowie der nachfolgenden Beschreibung, in der unter Bezugnahme auf die Zeichnung ein besonders bevorzugtes Ausführungsbeispiel im Einzelnen beschrieben ist. Dabei können die in der Zeichnung dargestellten und in den Ansprüchen sowie in der Beschreibung erwähnten Merkmale jeweils einzeln für sich oder in beliebiger Kombination erfindungswesentlich sein.

In der Zeichnung zeigen:
- Fig. 1: einen prinzipiellen Aufbau einer Prozeßkammer in geöffnetem Zustand;
- Fig.2: die geschlossene Prozeßkammer;
- Fig. 3: eine Substrataufnahme;
- Fig. 4: eine Schnittzeichnung der Prozeßkammer mit den dazugehörigen Antrieben;
- Fig. 5: einen Aufbau einer automatischen Anlage für die naßchemische Bearbeitung von Substraten.

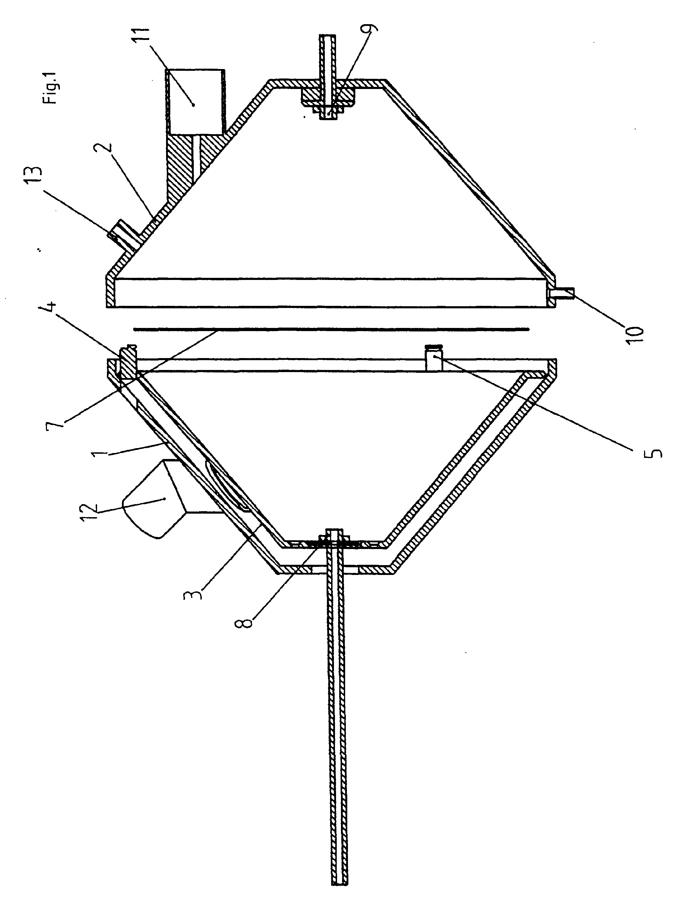

Die Fig. 1 zeigt den prinzipiellen Aufbau der Prozeßkammer in geöffnetem Zustand. Diese besteht aus zwei Prozeßkammerhälften 1 und 2 die zum Öffnen bzw. Schließen zueinander verfahrbar sind.

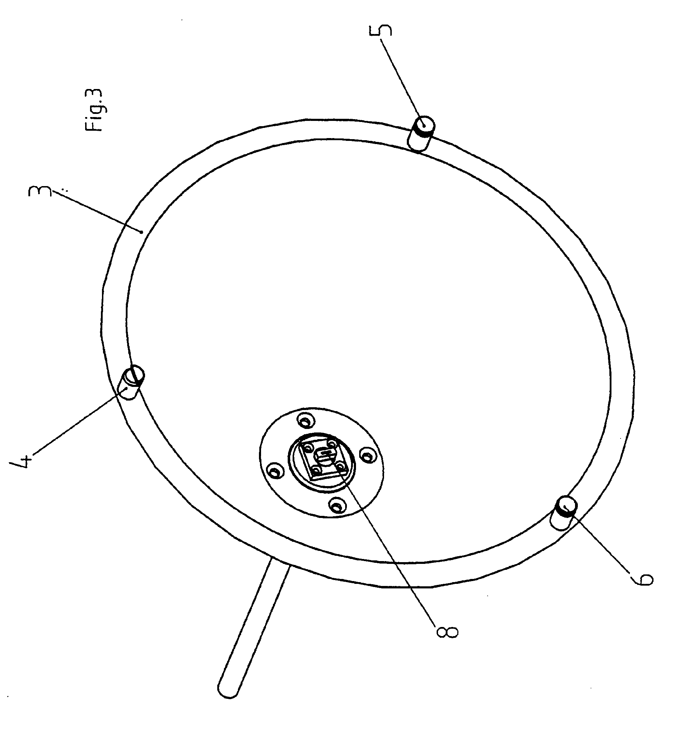

Innerhalb der Prozeßkammer befindet sich eine trichterförmige Substrataufnahme (Chuck) 3, die für die Aufnahme eines Substrats 7 über Aufnahmebolzen 4, 5 und 6, siehe hierzu auch Fig. 3, verfügt. Im Zentrum der Substrataufnahme (Chuck) 3, die durch einen Antrieb in Rotation versetzt werden kann, befindet sich eine Sprühdüse 8, die stationär angeordnet ist und auf die eine Seite des Substrats 7 sprüht. Die andere Substratseite des Substrats 7 wird über eine Düse 9 besprüht, die der anderen Prozeßkammerhälfte 2 zugeordnet ist und in deren Zentrum liegt. Die aufgesprühte und abgeschleuderte Flüssigkeit kann über einen Ablauf 10 aus der Prozeßkammer ablaufen.

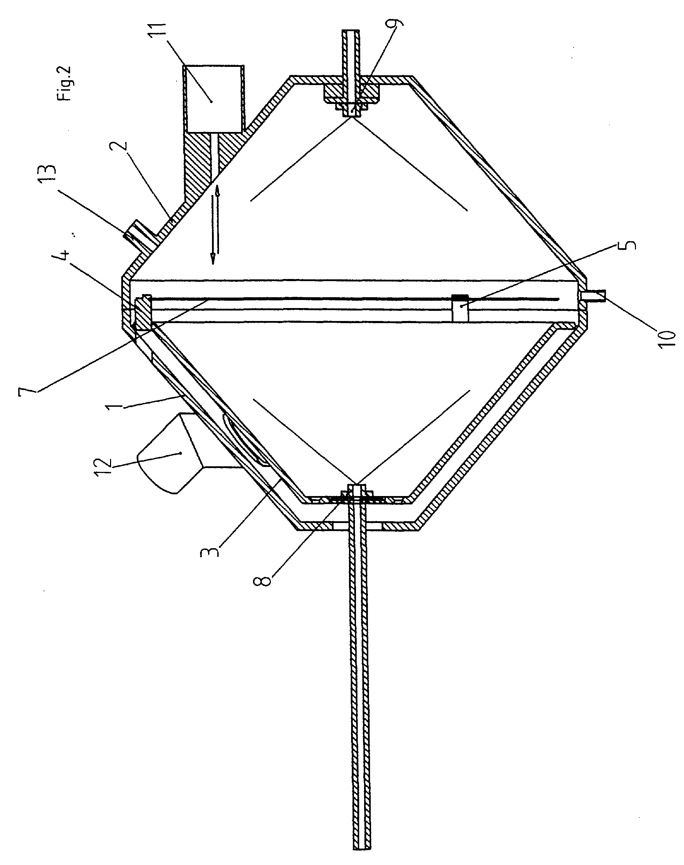

Die Fig. 2 zeigt die geschlossene Prozeßkammer mit der Möglichkeit des Einbaus eines "Endpoint"-Detektor 11 zur Prozesskontrolle, sowie einem Absaugstutzen 12, über den bei Bedarf Dämpfe aus der Prozeßkammer abgesaugt werden können. Über einen Gaseinlaßstutzen 13 kann die Prozeßkammer mit Gasen beaufschlagt werden.

Die Fig. 3 zeigt die Substrataufnahme (Chuck) 3. Das Substrat (nicht dargestellt) wird mit den Bolzen 4, 5, 6 gehalten. Der obere Bolzen 6 ist drehbar ausgeführt und durch die Bolzenform des Bolzen 6 wird das Substrat, welches auf den Bolzen 4 und 5 aufsitzt, nach der Drehung des Bolzens 6 gehalten. Hierfür ist der Bolzen 6 mit einer radialen und axialen Stufe versehen.

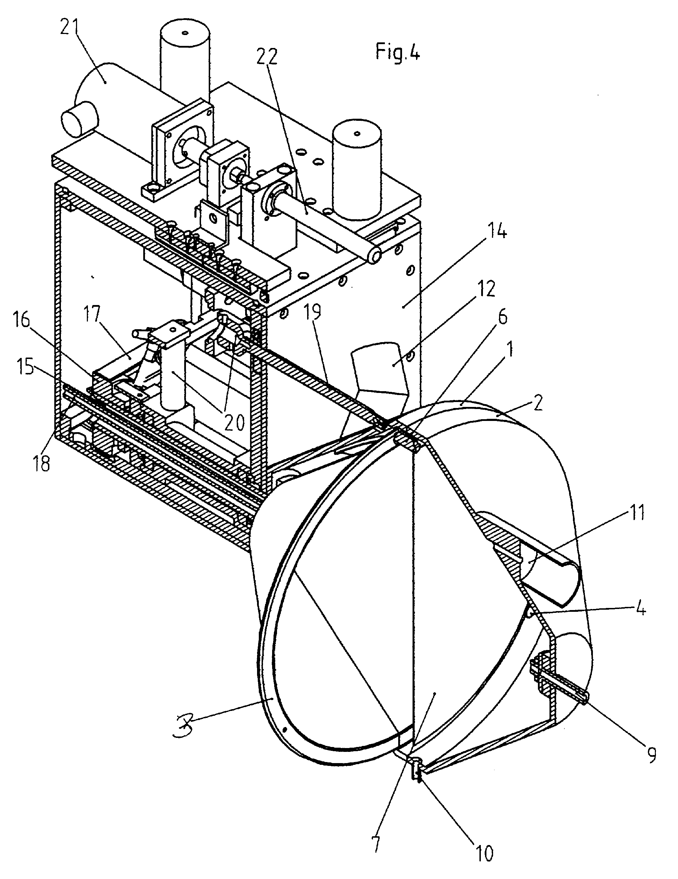

Die Fig. 4 zeigt eine Schnittzeichnung der Prozeßkammer mit den dazugehörigen zu einer Antriebseinheit 14 montierten Antrieben. Ein Antrieb dient zur Drehung des Substrats 7 innerhalb der Prozeßkammer. Das Substrat 7 wird zwischen den Bolzen 4, 5 und 6 der Substrataufnahme 3 gehalten. Die Substrataufnahme 3 ist an einer Hohlwelle 15 befestigt, welche über eine Zahnscheibe 16 und einen Zahnriemen 17 durch einen Motor angetrieben wird.

In der Hohlwelle 15 befindet sich die Medienzuführung 18 zur Sprühdüse 8 (siehe Fig. 3).

Ein Verschlußbolzen 19 dreht den Bolzen 6 der Substrataufnahme und verriegelt bzw. entriegelt das Substrat 7. Damit nach dem Verriegeln des Substrats 7 die Substrataufnahme 3 mit dem Substrat 7 rotieren kann, muß der Verschluß nach Verdrehen des Bolzen 6 wieder aus der Substrataufnahme 3 herausgefahren werden. Dazu ist der Verschlußbolzen 19 mit einem Antrieb verbunden, der sowohl den Verschluß 19 drehen kann, als auch den Bolzen in dessen Längsrichtung verfahren kann.

Um die Prozeßkammer zu öffnen, wird die gesamte Antriebseinheit 14, an welcher die eine Hälfte der Prozeßkammer fest montiert ist, durch einen Antrieb 21 über eine Gewindespindel 22 verfahren. Die vordere Hälfte der Prozeßkammer kann dabei stationär montiert werden. Die geöffnete Prozeßkammer kann über ein Handlingssystem mit Substraten 7 be- und entladen werden. Nach dem Beladen, wird das Substrat 7 auf der Substrataufnahme 3 durch den Verschlußbolzen 19 verriegelt. Danach werden die Prozeßkammerhälften 1 und 2 über Antrieb 21 mit der Gewindespindel 22 geschlossen. Über die Antriebseinheit 14 wird das Substrat 7 in der Kammer in Rotation versetzt und über die Düsen 8 und 9 von beiden Seiten mit Chemikalien besprüht.

Die Fig. 5 zeigt den Aufbau einer automatischen Anlage für die naßchemische Bearbeitung von Substraten 7, in welcher das vorher beschriebene Prozeßmodul für die chemischen Prozesse als Bestandteil der Anlage, z.B. Prozeßmodule 26 bis 30 eingebaut ist.

Die Substrate 7 werden von einem Substratvorrat 25 aus einem Magazin 32 auf eine Transporteinrichtung 33 eingelegt und zum Prozeßmodul 26 transportiert. Dort werden sie aus der Transporteinrichtung 33 in eine Reinigungsstation ausgehoben und gereinigt. Dadurch, daß die Substrate 7 aus der Transporteinrichtung 33 ausgehoben sind, kann diese wieder zurückfahren um das nächste Substrat 7 aufzunehmen. Durch das Hin- und Herfahren der Transporteinrichtung 33, wird die Crosskontamination (Verschleppen von Verunreinigung) innerhalb der gesamten Anlage vermieden.

Die Prozeßmodule 26 und 27 können z.B. für physikalische Reinigungsverfahren eingesetzt werden, wie Dampfreinigung, Bürstenreinigung, Megasonic, etc.. Die Prozeßmodule 28, 29 und 30 können für chemische Prozesse SC1, SC2, RCA, etc. in geschlossenen Prozesskammern verwendet werden.

Die Be- und Entladung der Prozesskammern erfolgt z.B. über Handlingsgreifer 34.

Die Trocknung des Substrats 7 erfolgt im Prozessmodul 31. Die getrockneten Substrate 7 werden im Magazin 35 abgelegt.

## Patentansprüche

1. Verfahren zum naßchemischen Reinigen und Ätzen von scheibenförmigen Substraten in einer geschlossenen Prozeßkammer, dadurch gekennzeichent, daß das zu bearbeitende Substrat (7) von einer Substrataufnahme (3) aufgenommen wird, daß das Substrat (7) in Rotation versetzt und gleichzeitig beide Seiten des Substrats (7) mit Chemikalien besprüht werden.

2. Vorrichtung zur Durchführung eines Verfahrens nach Anspruch 1, dadurch gekennzeichnet, daß die Prozeßkammer aus mindestens zwei Prozeßkammerhälften (1 und 2) besteht, welche in Richtung zueinander verfahren sind, wodurch die Prozeßkammer geöffnet und geschlossen werden kann.

3. Vorrichtung nach Anspruch 2, dadurch gekennzeichnet, daß die Substrataufnahme (3), welche in der Prozeßkammer sich befindet, bei offener Kammer über einen Handlingsgreifer (34) mit Substraten (7) beschickbar und entladbar ist.

4. Vorrichtung nach Anspruch 3, dadurch gekennzeichnet, daß die Substrataufnahme (3) über mindestens zwei feststehende Bolzen (5 und 6) verfügt, in welche das Substrat (7) durch den Handlingsgreifer (34) einlegbar ist und ein verdrehbarer oder verfahrbare Bolzen (6) das Substrat (7) in der Substrataufnahme (3) fixiert.

5. Vorrichtung nach einem der Ansprüche 2 bis 4, dadurch gekennzeichnet, daß die Substrataufnahme (3) in Form eines Trichters ausgebildet ist, in dessen Mitte sich eine oder mehrere feststehende Chemikaliensprühdüsen (8, 9) befinden, die auf das rotierende Substrat (7) sprühen.

6. Vorrichtung nach einem der Ansprüche 2 bis 5, dadurch gekennzeichnet, daß die Prozeßkammerhälfte (1 und/oder 2) über mindestens ein Ablauf (10) verfügt, um das aufgesprühte, vom Substrat (7) weggeschleuderte Medium aus der Prozeßkammer zu sammeln.

7. Vorrichtung nach einem der Ansprüche 2 bis 6, dadurch gekennzeichnet, daß die Prozeßkammer über eine oder mehrere Absaugstutzen (12) verfügt, um entstehende Dämpfe bzw. Gase abzusaugen.

8. Vorrichtung nach einem der Ansprüche 2 bis 7, dadurch gekennzeichnet, daß die Prozeßkammer über einen Gaseinlaßstutzen (13) zur Beaufschlagung der Prozeßkammer mit Schutzgasen (z.B. N₂, O₂, etc.) verfügt, um chemische Prozesse beim Sprühen von Chemikalien auf das Substrat (7) zu steuern.

9. Vorrichtung nach einem der Ansprüche 2 bis 8, dadurch gekennzeichnet, daß Sprühdüsen (8 und 9) vorgesehen unterschiedlichem Öffnungswinkel und/oder unterschiedlicher Sprühform (Flachstrahl, Vollstrahl) vorgesehen sind, die als Einstoff- aber auch Mehrstoffdüsen einsetzbar sind.

10. Vorrichtung nach Anspruch 9, dadurch gekennzeichnet, daß die Sprühdüse (8 und/oder 9) im Abstand zum Substrat (7) verstellbar und verfahrbar ist, um Substratsegmente bzw. das Gesamtsubstrat zu besprühen.

11. Vorrichtung nach einem der Ansprüche 9 und 10, dadurch gekennzeichnet, daß durch die Sprühdüse (8 und/oder 9) zur automatischen Prozeßkammerreinigung z.B. mit DI-H₂O verwendbar ist.

12. Vorrichtung nach einem der Ansprüche 9 bis 11, dadurch gekennzeichnet, daß die Sprühdüsen (8 und/oder 9) als Misch- oder Mehrstoffdüsen ausgebildet sind, so daß die Mischung der Chemikalien erst in der Sprühdüse (8 bzw. 9) erfolgt.

13. Vorrichtung nach einem der Ansprüche 9 bis 12, dadurch gekennzeichnet, daß die Einzelchemikalien aus jeweils einer Düse versprühbar sind und die Mischung erst bei Auftreffen der Chemikalien auf das Substrat (7) erfolgt.

14. Vorrichtung nach einem der Ansprüche 2 bis 14, dadurch gekennzeichnet, daß die Einstellung der Drehzahl der Substratrotation und das Aufsprühen der Chemikalien zueinander einstellbar sind und so abstimmbar ist, daß der Chemikalienverbrauch minimierbar ist.

15. Vorrichtung nach einem der Ansprüche 2 bis 14, dadurch gekennzeichnet, daß Prozeßdetektoren (11), z.B. in Form von Endpunktdetektoren basierend auf Reflexion, vorgesehen sind, mit denen der Prozeß für jedes Substrat (7) optimal steuerbar ist.

16. Vorrichtung nach einem der Ansprüche 2 bis 15, dadurch gekennzeichnet, daß mehrere Prozeßkammern für unterschiedliche Prozesse oder mehrere gleiche Prozesse nacheinander als Prozeßmodule (26 bis 31) geschaltet sind.

17. Vorrichtung nach Anspruch 16, dadurch gekennzeichnet, daß eine lineare Transporteinrichtung (33) für den Substrattransport des insbesondere vertikal ausgerichteten Substrats (7) zu und zwischen den Prozessmodulen (26 bis 31) vorgesehen ist.

18. Vorrichtung nach Anspruch 16, dadurch gekennzeichnet, daß die Transporteinrichtung (33) jeweils nur um eine Prozessmodulbreite hin und her taktet.
